(19) **Europäisches Patentamt / European Patent Office / Office européen des brevets**

(11) **EP 1 396 728 B1**

(12) # EUROPEAN PATENT SPECIFICATION

(45) Date of publication and mention
of the grant of the patent:
**06.06.2012 Bulletin 2012/23**

(51) Int Cl.:
*G01R 21/00* (2006.01)      *G01R 21/127* (2006.01)

(21) Application number: **03254220.1**

(22) Date of filing: **02.07.2003**

(54) **Device for measuring a power consumption**

Vorrichtung zum Messen eines Energieverbrauchs

Dispositif pour mesurer une consommation d'énergie

(84) Designated Contracting States:
**DE FR GB IT NL**

(30) Priority: **06.09.2002 KR 2002053825**

(43) Date of publication of application:
**10.03.2004 Bulletin 2004/11**

(73) Proprietor: **Samsung Electronics Co., Ltd.**
**Suwon-si,**
**Gyeonggi-do 442-742 (KR)**

(72) Inventor: **Choi, Young-hun**
**Paldal-gu,**
**Suwon-si,**
**Gyeonggi-do (KR)**

(74) Representative: **Walaski, Jan Filip et al**
**Venner Shipley LLP**
**200 Aldersgate**
**London**
**EC1A 4HD (GB)**

(56) References cited:
**US-B1- 6 320 766      US-B1- 6 381 151**

- **PATENT ABSTRACTS OF JAPAN vol. 2000, no. 15, 6 April 2001 (2001-04-06) & JP 2000 341950 A (MATSUSHITA ELECTRIC WORKS LTD), 8 December 2000 (2000-12-08)**
- **Robert J. Hofinger: "64. Switching Power Supplies" In: Editor-in-Chief: Jerry C. Whitaker: "The Electronics Handbook", 1 January 1996 (1996-01-01), CRC Press ISBN: 0849383455 pages 957-967,**

**Description**

The present invention relates to an apparatus having a switch-mode power supply, comprising a switch and a transformer.

Power consumption is a quantitative indication of the ratio of how much energy is consumed or how much work is done per unit of time, and indicates the amount of energy supplied or consumed in a unit second. The energy consumption efficiency grade of a product varies in accordance with the power consumption, and a low-grade product wastes energy during the entire life of the product. Therefore, it is desirable for a user to be able to confirm the energy consumption efficiency grade of a product and purchase a higher-grade product if possible.

As consumer concerns regarding energy savings have recently increased, various products now have a power saving function and keep the power consumption below a certain level even during normal operation. However, it would be highly desirable to indicate the actual power consumption of a product while the product is in use. Displaying the actual power consumption has not been considered previously due to the complexity of the circuit needed to implement such a function and the cost of doing so. Accordingly, the actual power consumption of a product must be measured in the product development stage using a separate measuring device at AC input lines to which power is supplied. Furthermore, consumers have not had a way to know the actual power consumption of a product when it is in use, other than the maximum power consumption stated in the product manual or on a label attached to the product. However, as consumers' understanding of energy saving functions and efficiencies have gradually changed, a need has arisen to provide a function for measuring, in real-time, and indicating the power consumption of a product while the product is in use.

US 6,320,766 B1 discloses a power-saving circuit for an AC/DC adaptor, having a feedback unit producing a feedback voltage based on an output voltage. A flyback regulator, comprising a switching transformer, is disclosed in "The Electronics Handbook", Editor-in-Chief: Jerry C. Whitaker, First Edition, ISBN: 0849383455, CRC Press, 1996 (pp. 965-967).

According to the present invention, there is provided an apparatus according to claim 1 and a method of calculating power consumption according to claim 8.

An apparatus having a switch-mode power supply, comprising a switch and a transformer, according to the present invention, is characterised by power consumption measuring means, comprising voltage limiting means for limiting the voltage across a secondary coil of said transformer and means configured to generate a power consumption value in dependence on the duty cycle and the frequency of the output of the voltage limiting means. Thus, means for measuring the power consumption of a product, in real time, are provided.

Preferably, the apparatus comprises display means for showing the power consumption value to a user. Thus, means for indicating the power consumption of a product are provided

Preferably, the apparatus comprises first and second transformers wherein the power consumption measuring means is connected to the secondary coil of the second transformer and the first transformer is used to power functional elements of the apparatus.

Embodiments of the present invention will now be described, by way of example, with reference to Figures 1 to 4I of the accompanying drawings, in which:

Figure 1 is a circuit diagram of an embodiment of an apparatus for measuring power consumption according to the present invention;
Figures 2A-2G show waveforms for explaining an operation of the apparatus shown in Figure 1;
Figure 3 is a circuit diagram of another embodiment of an apparatus for measuring power consumption according to the present invention; and
Figures 4A-4I show waveforms for explaining an operation of the apparatus shown in Figure 3.

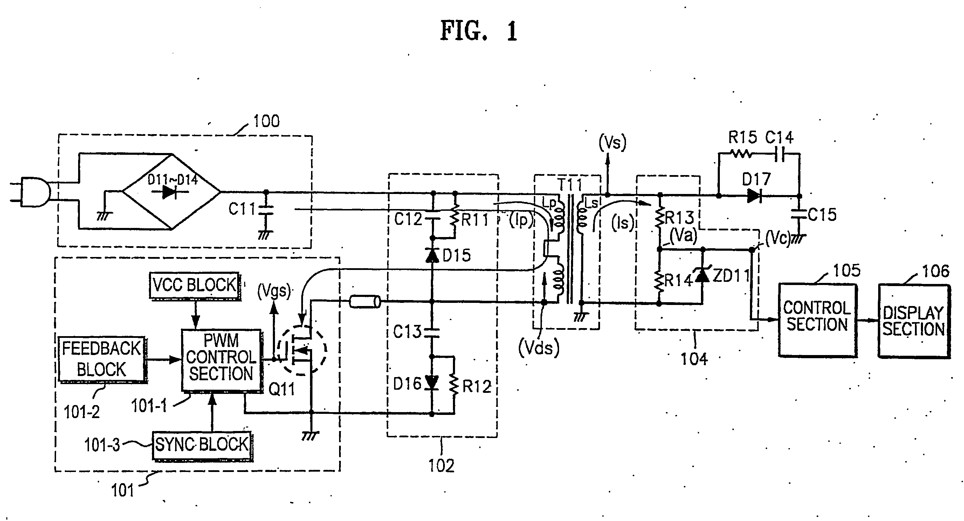

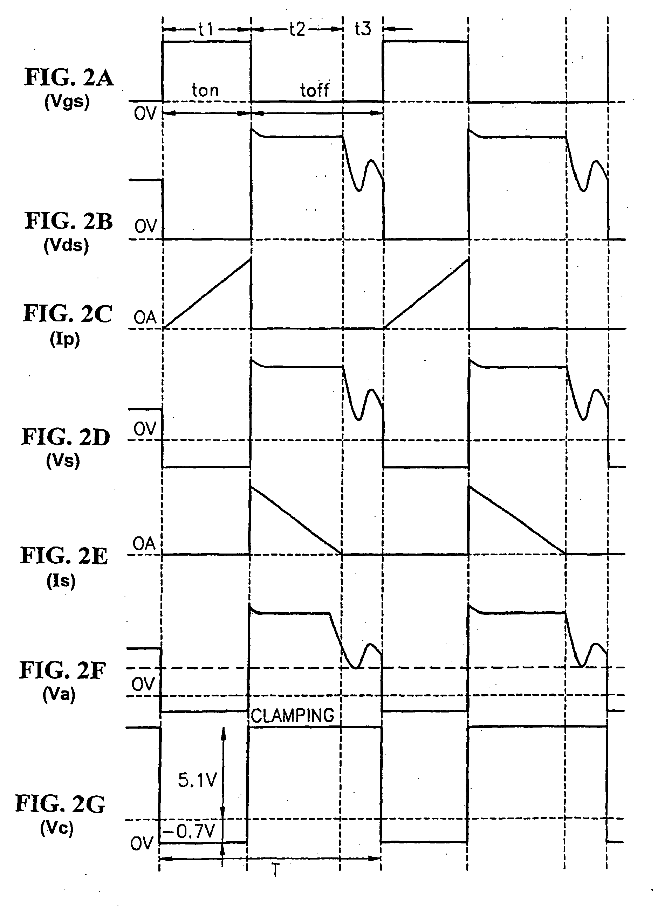

Referring to Figures 1 and 2A-2G, a method of measuring power consumption using the voltage $V_s$ at the secondary coil of the transformer T11 will now be described. The apparatus shown in Figure 1 comprises a rectifying section 100, a switching section 101, a snubber circuit 102, a transformer T11, a voltage regulating section (or voltage limiting means) 104, a control section 105 and a display section 106.

The rectifying section 100 rectifies and smoothes an input AC mains voltage to produce a DC voltage. The smoothed DC voltage is applied to a first end of a primary coil of the transformer T11. The switching section 101 switches current through the primary coil of the transformer T11 in accordance with pulse-width modulation (PWM) control signals. The switching section 101 comprises a PWM control section 101-1 which generates PWM signals based on feedback voltages from a feedback block 101-2 and synchronous signals from a synchronous (SYNC) block 101-3, and a field effect transistor (FET) Q11 which switches the current through the primary coil in response to the PWM signals.

The snubber circuit 102 prevents the destruction of the FET Q11 by suppressing surge voltages generated when the FET Q11 turns off. The snubber circuit 102 comprises an upper snubber circuit comprising a resistor R11, a capacitor C12 and a diode D15, and a lower snubber circuit comprising a resistor R12, a capacitor C13 and a diode D16. With regard to the upper snubber circuit, when the FET Q11 turns-off, a surge voltage generated at the primary coil of the transformer T11 rapidly increases, and if the surge voltage exceeds a predetermined voltage, then the switching section 101 is destroyed. Therefore, the upper snubber circuit prevents the destruction of the FET Q11 by suppressing voltage surges in such a way that the voltage surge generated when the FET Q11 turns off charges the capacitor C12 through the diode D15 and then gradually discharges through the resistor R11. The lower snubber circuit prevents the destruction of the FET Q11 by suppressing a surge voltage when the FET Q11 turns off, so that the surge voltage generated at the primary coil of the transformer T11 charges capacitor C13 through the diode D16 and then gradually discharges through the resistor R12.

The transformer 103 stores energy at its primary coil $L_p$ when the FET Q11 turns on and provides energy to the secondary coil $L_s$ when the FET Q11 turns off. Operation of the transformer 103 in time intervals t1, t2 and t3 will now be described with reference to Figures 2A to 2G. Referring to Figure 2A, during the time interval t1, when a gate voltage ($V_{gs}$) of about 10V is applied to the FET Q11, the FET Q11 turns on and, accordingly, the voltage $V_{ds}$ becomes 0V (Figure 2B). The smoothed DC voltage from the rectifying section is applied across the primary coil $L_p$ of the transformer 103 and a current $I_p$ starts to flow (Figure 2C). When the current $I_p$ flows, the primary coil $L_p$ is charged with an energy of ½*$L_p$*$I_p^2$ joules.

During this time, since an emf having the opposite polarity is induced in the secondary coil $L_s$ (Figure 2D), a current $I_s$ does not flow (Figure 2E).

During the time interval t2, the FET Q11 turns off at the instant the gate voltage $V_{gs}$ of the FET Q11 becomes 0V (Figures 2A and 2B) and, accordingly, the current $I_p$ does not flow (Figure 2C) so a back emf is induced in the primary coil $L_P$. Therefore, the inductor energy, ½*$L_p$*$I_p^2$ joules, stored at the primary coil $L_p$, moves to the secondary coil (Figure 2D). During the time interval t3, after all of the energy stored at the primary coil has been transferred to the secondary coil, the current $I_s$ becomes 0A (Figure 2E) so that no more current flows through the secondary coil.

The diodes D11 to D14 of the rectifying section 100 rectify and smooth the AC voltages at the capacitor C11 in accordance with the following equation (1):

$$V_i(dc) = V_{in}(ac) \times \sqrt{2} \times 0.9 \quad [V_{dc}] \quad ...(1)$$

At the instant the FET Q11 switches on, the current $I_p$ flows from the capacitor C11 to the FET Q11, and the power consumption at this instant corresponds to the following equation (2):

$$P = \frac{1}{2} L_p \times I_p^2 \times f \quad [W] \quad ...(2)$$

In equation (2), f is the switching frequency of the switching section 101, and $L_p$ is the inductance of the primary coil of the transformer T11, which is known to the manufacturer. Therefore, if the current $I_p$ is known at the instant the FET Q11 turns on, the resultant power consumption may be determined using equation (2). However, there is a difficulty in measuring the value of the current $I_p$, because a dedicated measuring device is normally required for that purpose. Nevertheless, the value of the current $I_p^{max}$ may be obtained from the following equation (3):

$$I_p^{max} = \frac{1}{L_p}(V_i \times t_{on}) \quad [A] \quad ...(3)$$

That is, the value of the current $I_p^{max}$ may be obtained using the turn-on time of the FET Q11, and the resultant power consumption may be determined using equation (4):

$$P = \frac{1}{2} \frac{V_i^2 \times t_{on}^2}{L_p} \times f \quad [W] \quad ...(4)$$

Therefore, if the turn-on time of the FET Q11 is known, the resultant power consumption may be determined using equation (4).

The voltage regulating section 104 that provides the signals for measuring the turn-on time of the FET Q11 using the voltage $V_s$ at the secondary coil of the transformer T11 will now be described.

Referring to Figure 2D, at the instant the FET Q11 turns off, the waveform of the voltage $V_s$, which is generated at the secondary coil of the transformer T11 due to the counter electromotive force, rises. As shown in Figure 2D, the time interval when the secondary voltage $V_s$ decreases below the ground level corresponds to the turn-on time of the FET Q11. In the voltage regulating section 104 shown in Figure 1, the resistors R13, R14 form an attenuator which decreases the secondary voltage $V_s$ to provide an attenuated waveform $V_a$ shown in Figure 2F. A clamp device such as a Zener diode ZD11 clamps voltages above 5.1V to 5.1V and voltages below -0.7V to -0.7V to provide a clamped waveform $V_c$ shown in Figure 2G and outputs the clamped signal to the control section 105.

The control section 105 calculates the switching frequency (1/T) of the switching section 101, which is provided from the voltage regulating section 104, and the turn-on time of the FET Q11, which corresponds to the time interval shown as the low level area in Figure 2G. Therefore, the resultant power consumption may be obtained by substituting the calculated turn-on time of the FET Q11 in equation (4). The calculated power consumption may be indicated by a display section 106, if consumers wish to have such a display.

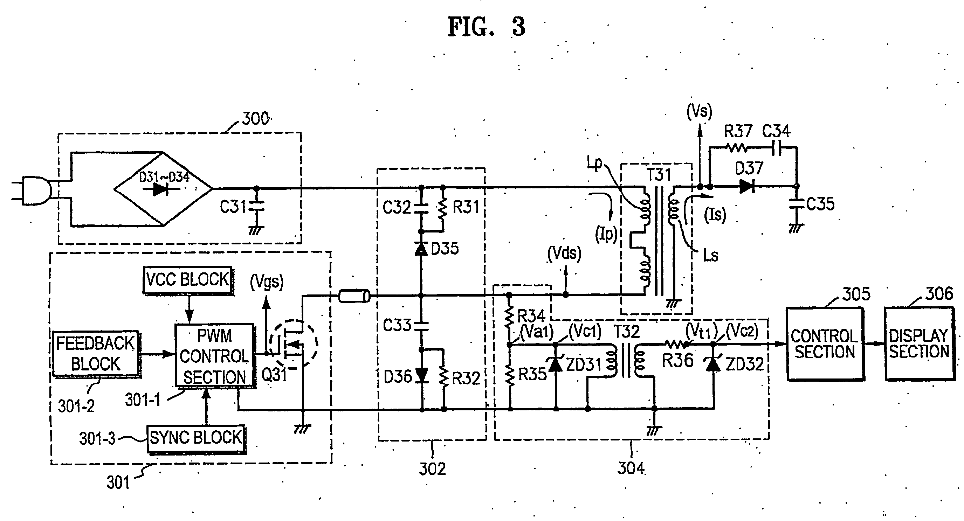

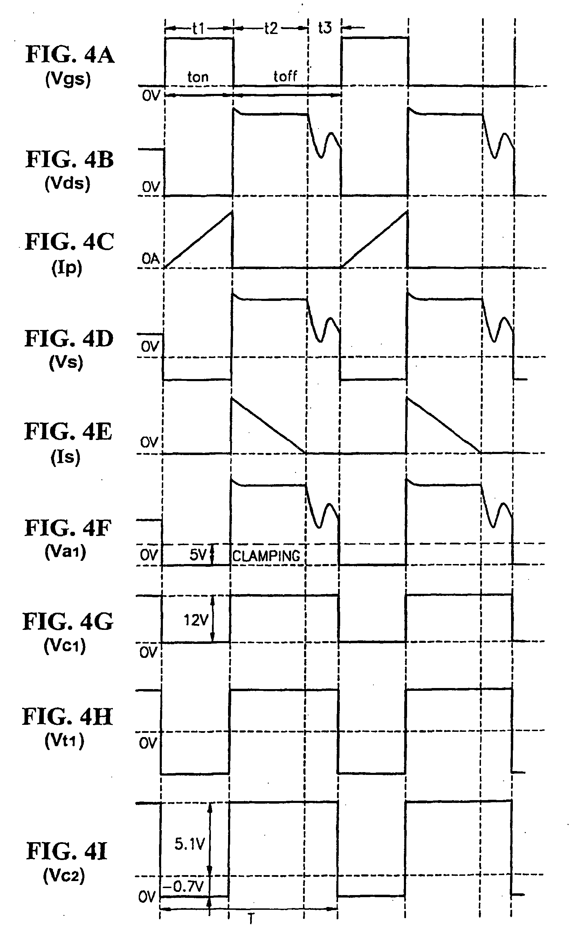

Referring to Figures 3 and 4A to 4I, a method of measuring power consumption using the voltage $V_{ds}$ at the primary coil of a transformer 303 will now be described. The apparatus shown in Figure 3 comprises, a rectifying section 300, a switching section 301, a snubber circuit 302, a transformer T31, a voltage regulating section 304, a control section 305, and a display section 306.

The rectifying section 300 rectifies and smoothes an input AC mains voltage to produce a DC voltage. The smoothed DC voltage is applied to a first end of a primary coil $L_p$ of the transformer T31. The switching section 301 switches current through the primary coil of the transformer T31 in accordance with PWM control signals. The switching section 301 comprises a PWM control section 301-1 which generates PWM signals based on feedback voltages from a feedback block 301-2 and synchronous signals from a synchronous (SYNC) block 301-3, and a field effect transistor (FET) Q31 switches the second end of the primary coil $L_p$ in response to the PWM signals.

The snubber circuit 302 prevents the destruction of the FET Q31 by suppressing surge voltages generated when the FET Q31 turns off. The snubber circuit 302 comprises an upper snubber circuit comprising a resistor R31, a capacitor C32 and a diode D35, and a lower snubber circuit comprising a resistor R32, a capacitor C33 and a diode D36. With regard to the upper snubber circuit, when the FET Q31 turns-off, a surge voltage generated at the primary coil $L_p$ of the transformer T31 rapidly increases, and if the surge voltage exceeds a predetermined voltage, then the switching section 301 is destroyed. Therefore, the upper snubber circuit prevents destruction of the FET Q31 by suppressing voltage surges in such a way that the voltage surge generated when the FET Q31 turns off charges the capacitor C32 through the diode D35 and then gradually discharges through the resistor R31. The lower snubber circuit prevents destruction of the FET Q31 by suppressing surge voltages when the FET Q31 turns off, so that the surge voltage generated at the primary coil of the transformer T31 charges the capacitor C33 through the diode D36 and then gradually discharges through the resistor R32.

The transformer T31 stores energy in the primary coil $L_p$ when the FET Q31 turns on and provides energy to a secondary coil $L_s$ when the FET Q31 turns off. The operation of the transformer T31 in the time intervals t1, t2 and t3 will now be described with reference to Figures 4A through 4I. During the time interval t1, a gate voltage ($V_s$) of about 10V is applied to the FET Q31 (Figure 4A), the FET Q31 turns on and, accordingly, the voltage $V_{ds}$ becomes 0V (Figure 4B). With the DC input voltage applied across the primary coil $L_p$ of the transformer T31, a current $I_p$ starts to flow (Figure 4C). When the current $I_p$ flows, the primary coil $L_p$ is charged with energy of ½*$L_p$*$I_p^2$ joules. At this moment, since an emf having the opposite polarity is induced in the secondary coil $L_s$ (Figure 4D), the current $I_s$ does not flow (Figure 4E). During the time interval t2, the FET Q31 turns off when the gate voltage $V_{gs}$ of the FET Q31 becomes 0V (Figures 4A and 4B) and, accordingly, the current $I_p$ does not flow (Figure 4C) so a back emf is induced in the primary coil $L_p$. Therefore, the inductor energy, ½*$L_p$*$I_p^2$ joules, stored at the primary coil $L_p$ moves to the secondary coil $L_s$ (Figure 4D). During the time interval t3, after all of the energy stored at the primary coil has been transferred to the secondary coil, the current $I_s$ becomes 0A (Figure 4E) so that no more current flows through the secondary coil.

The diodes D31 through D34 of the rectifying section 300 rectify and smooth the AC voltages at the capacitor C31 in accordance with the following equation (5):

$$V_i(dc) = V_{in}(ac) \times \sqrt{2} \times 0.9 \qquad [V_{dc}] \quad ...(5)$$

At the instant when the FET Q31 switches on, the current $I_p$ flows from the capacitor C31 through the FET Q31, and the power consumption at the instant of switching corresponds to the following equation (6):

$$P = \frac{1}{2} L_p \times I_p^2 \times f \qquad [W] \quad ...(6)$$

In the above equation (6), $f$ is the switching frequency of the switching section 101, and $L_p$ is the inductance of the primary coil of the transformer, which is known to the manufacturer. Therefore, if the current $I_p$ is known at the instant when the FET Q31 turns on, the resultant power consumption may be calculated using equation (6). However, there is a difficulty in measuring the value of the current $I_p$, because a dedicated measuring device is normally required for that purpose. Nevertheless, the value of the current $I_p^{max}$ can be obtained from the following equation (7):

$$I_p^{max} = \frac{1}{L_p}(V_i \times t_{on}) \qquad [A] \quad ...(7)$$

That is, the value of the current $I_p^{max}$ may be obtained using the turn-on time of the FET Q31, and the resultant power consumption may be determined using equation (8):

$$P = \frac{1}{2} \frac{V_i^2 \times t_{on}^2}{L_p} \times f \qquad [W] \quad ...(8)$$

Therefore, if the turn-on time of the FET Q31 is known, the resultant power consumption can be determined using equation (8).

The voltage regulating section 304 provides signals for calculating the turn-on time of the FET Q31 using the voltage $V_{ds}$ at the primary coil of the transformer T31 and will now be described.

Resistors R34 and R35 form an attenuator which attenuates the level of the primary voltage $V_{ds}$ shown in Figure 4B to a convenient level, such as for example, a level of 1/20 $V_{ds}$. The waveform of the attenuated primary voltage $V_{a1}$ is illustrated in Figure 4F. A first clamp device, such as a Zener diode ZD31, clamps the voltage of the attenuated primary voltage $V_{a1}$ above 12V to 12V ($V_{c1}$) as shown in Figure 4G. A transformer T32 transfers the clamped primary voltage $V_{c1}$ to a secondary coil thereof as a voltage $V_{t1}$. The mutual inductances of the transformer T32 result in an alternating waveform as shown in Figure 4H. The upper and lower portions of the waveform in Figure 4H have the same amplitude with respect to 0V. A second clamp device, such as a Zener diode ZD32, clamps voltages above 5.1V to 5.1V and voltages below -0.7V to -0.7V to produce waveform $V_{c2}$ shown in Figure 4I and outputs the clamped signal to the control section 305.

The control section 305 calculates the switching frequency (1/T) of the switching section 301, which is provided from the voltage regulating section 304, and the turn-on time of the FET Q31, which corresponds to the time interval shown as the low level area (-0.7V) in Figure 4I. Therefore, the resultant power consumption may be obtained by substituting the calculated turn-on time of the FET Q31 in equation (8). The calculated power consumption may be indicated by a display section 306, if consumers wish to have such a display.

According to the above description, a method of measuring power consumption by using the voltage $V_s$ at the secondary coil of a transformer T11 or a method for measuring power consumption by using the voltage $V_{ds}$ at the primary coil of a transformer T31 is provided. However, a circuit may be constructed in view of the above disclosure, which implements both methods in the same circuit.

According to the present invention, by measuring, in real-time, and indicating the power consumption of a product using a SMPS as described above, normal operation of the product may be confirmed by consumers and the reliability of the product is improved.

**Claims**

1. An apparatus for measuring power consumption comprising a switch-mode power supply, said switch-mode power supply comprising a switch (Q11; Q31) and a transformer (T11; T31) said transformer comprising a primary coil and a secondary coil, and the apparatus further comprises:

   a rectifying unit (100; 300) arranged to rectify and smooth an AC voltage input to the rectifying unit to output a DC voltage;
   a voltage regulating unit (104; R36, ZD32) arranged to regulate at least one of a first voltage ($V_{C2}$) derived from a voltage at the primary coil of said transformer (T31) and a second voltage ($V_C$) derived from a voltage at the secondary coil of said transformer (T11); and
   wherein the primary coil is arranged to receive said DC voltage and the secondary coil is arranged to produce a voltage ($V_S$) in accordance with current fluctuations in the primary coil, and
   wherein the switch is arranged to switch on or off the DC voltage at the primary coil with pulse-width modulation PWM,
   **characterised in that** the apparatus further comprises
   a control unit (105; 305) configured to calculate an ON time of the switch based on the at least one regulated voltage output by the voltage regulating unit (104; R36, ZD32), and to calculate a power consumption value based on the calculated ON time, a switching frequency of the switch and an inductance of the transformer.

2. The apparatus according to claim 1, comprising display means (106; 306) for showing the power consumption value to a user.

3. The apparatus according to claims 1 or 2, comprising first and second transformers (T31, T32) wherein the voltage regulating unit is connected to the secondary coil of the second transformer (T32) and the first transformer (T31) is used to power functional elements of the apparatus.

4. The apparatus according to claim 1 or 2, wherein the voltage regulating unit is arranged to regulate said first voltage, the voltage regulating unit comprising:

   a voltage decreasing section (R34, R35) arranged to decrease said first voltage below a certain level;
   a first clamp (ZD31) arranged to clamp the decreased first voltage at a first constant voltage level;
   a transformer (T32) arranged to transform the clamped first voltage; and
   a second clamp (ZD32) arranged to clamp the transformed first voltage at a second constant voltage level.

5. The apparatus according to claim 1 or 2, wherein the voltage regulating unit is arranged to regulate said second voltage, the voltage regulating unit comprising:

   a voltage decreasing section (R13, R14) arranged to decrease said second voltage below a certain level; and
   a clamp (ZD11) arranged to clamp the decreased second voltage at a constant voltage level.

6. The apparatus according to claim 1, further comprising:

   a pulse width modulator (101-1) arranged to provide a pulse width modulation signal to the switch, according to a control signal;
   wherein the primary coil has a first end, a second end and a predetermined inductance, one end of the primary coil being connected to a DC voltage,
   wherein the switch is connected to the second end of the primary coil and is arranged to switch a current in the primary coil ON and OFF according to the pulse width modulation signal, and
   wherein the control unit is arranged to determine an ON time of the current and a switching frequency of the pulse width modulation signal based on the output of the voltage regulating unit, and to calculate the power consumption value based on the ON time of the current, the switching frequency of the pulse width modulation, a value of the DC voltage and the predetermined primary coil inductance.

7. The apparatus according to any preceding claim, wherein the control unit is arranged to calculate the power consumption value according to an equation:

$$P = \frac{1}{2} \frac{V_i^2 \times t_{on}^2}{L_p} \times f(W),$$

where:

P is the calculated power consumption value,
$V_i$ is a value of the voltage at the primary coil,
$L_p$ is an inductance of the primary coil,
$t_{on}$ is an ON time of the current in the primary coil, and
f(W) is a switching frequency of the switch.

8. A method of calculating power consumption of an apparatus comprising a switch-mode power supply, said switch-mode power supply comprising a switch (Q11; Q31) and a transformer (T11; T31), the method comprising:

rectifying and smoothing an AC voltage to output a DC voltage;
regulating at least one of a first voltage ($V_C$) derived from a voltage at a primary coil of said transformer (T31) and a second voltage ($V_{C2}$) derived from a voltage at a secondary coil of said transformer (T11);
receiving said DC voltage at the primary coil and producing a voltage ($V_S$) at the secondary coil in accordance with current fluctuations in the primary coil, and
switching on or off the DC voltage at the primary coil with pulse-width modulation PWM; and
calculating an ON time of the switch based on the at least one regulated voltage, and calculating a power consumption value based on the calculated ON time, a switching frequency of the switch and an inductance of the transformer.

9. The method according to claim 8, wherein a current of a primary coil of the transformer is turned ON and OFF by pulse-width modulation, the method further comprising:

determining a drive voltage across the primary coil;
generating a pulse waveform having a first level corresponding to an ON time of the current in the primary coil and a second level;
determining a magnitude of the current based on the drive voltage across the primary coil, the ON time of the current in the primary coil, and a predetermined inductance of the primary coil; and
calculating the power consumption value based on an equation:

$$P = \frac{1}{2} \frac{V_i^2 \times t_{on}^2}{L_p} \times f(W),$$

where:

P is the calculated power consumption value,
$V_i$ is the drive voltage,
$L_p$ is the predetermined inductance of the primary coil,
t is the ON time of the current in the primary coil, and
f(W) is a switching frequency of the pulse width modulation.

10. The method according to claim 9, further comprising:

sampling the drive voltage;
clamping the sampled drive voltage at predetermined maximum and minimum values; and
determining the ON time from the clamped voltage.

11. The method according to claim 10, wherein the sampling of the drive voltage comprises:

transforming the drive voltage using a second transformer (T32) having a predetermined turns ratio to output the sampled drive voltage.

**12.** The method according to claim 10, wherein the sampling of the drive voltage comprises:

attenuating the drive voltage according to a predetermined ratio to output the sampled drive voltage.

**Patentansprüche**

**1.** Vorrichtung zum Messen von Energieverbrauch, die eine Schalterbetriebsstromversorgung umfasst, wobei die besagte Schalterbertiebsstromversorgung einen Schalter (Q11; Q31) und einen Transformator (T11; T31) umfasst, wobei der besagte Transformator eine Primärspule und eine Sekundärspule umfasst und die Vorrichtung weiter umfasst:

eine Gleichrichtungseinheit (100; 300), die eingerichtet ist, einen Wechselspannungseingang zur Gleichrichtungseinheit gleichzurichten und zu glätten, um eine Gleichspannung auszugeben;
eine Spannungsregeleinheit (104; R36, ZD32), die eingerichtet ist, zumindest eine erste Spannung ($V_{c2}$), die von einer Spannung an der Primärspule des besagten Transformators (T31) abgeleitet ist, und eine zweite Spannung ($V_c$) zu regeln, die von einer Spannung an der Sekundärspule des besagten Transformators (T11) abgeleitet ist; und
wobei die Primärspule eingerichtet ist, die besagte Gleichspannung zu empfangen und die Sekundärspule eingerichtet ist, eine Spannung (Vs) in Übereinstimmung mit Stromschwankungen in der Primärspule zu erzeugen, und
wobei der Schalter eingerichtet ist, die Gleichspannung an der Primärspule mit Pulsweitenmodulation (PWM) ein- oder auszuschalten, **dadurch gekennzeichnet, dass** die Vorrichtung weiter umfasst:

eine Steuereinheit (105; 305), die konfiguriert ist, eine EIN-Zeit des Schalters beruhend auf der zumindest einen, von der Spannungsregeleinheit (104; R36, ZD32) geregelten, Spannungsausgangsleistung zu berechnen und einen Stromverbrauchswert beruhend auf der berechneten EIN-Zeit, eine Schalthäufigkeit des Schalters und eine Induktanz des Transformators zu berechnen.

**2.** Vorrichtung nach Anspruch 1, die ein Anzeigemittel (106; 306) umfasst, um einem Benutzer den Stromverbrauchswert zu zeigen.

**3.** Vorrichtung nach Ansprüchen 1 oder 2, die erste und zweite Transformatoren (T31, T32) umfasst, wobei die Spannungsregeleinheit an die Sekundärspule des zweiten Transformators (T32) angeschlossen ist und der erste Transformator (T31) verwendet wird, Funktionselemente der Vorrichtung mit Strom zu versorgen.

**4.** Vorrichtung nach Anspruch 1 oder 2, wobei die Spannungsregeleinheit eingerichtet ist, die besagte erste Spannung zu regeln, wobei die Spannungsregeleinheit umfasst:

einen Spannungssenkungsteil (R34, R35), der eingerichtet ist, die besagte erste Spannung unter einen gewissen Pegel zu senken;
eine erste Klemme (ZD31), die eingerichtet ist, die gesenkte erste Spannung auf einen ersten konstanten Spannungspegel zu klemmen;
einen Transformator (T32), der eingerichtet ist, die geklemmte erste Spannung zu transformieren; und
eine zweite Klemme (ZD32), die eingerichtet ist, die transformierte erste Spannung auf einem zweiten konstanten Spannungspegel zu klemmen.

**5.** Vorrichtung nach Anspruch 1 oder 2, wobei die Spannungsregeleinheit eingerichtet ist, die besagte zweite Spannung zu regeln, wobei die Spannungsregeleinheit umfasst:

einen Spannungssenkungsteil (R13, R14), der eingerichtet ist, die besagte zweite Spannung unter einen gewissen Pegel zu senken; und
eine Klemme (ZD11), die eingerichtet ist, die gesenkte zweite Spannung auf einem konstanten Spannungspegel zu klemmen.

6. Vorrichtung nach Anspruch 1, weiter umfassend:

einen Pulsweitenmodulator (101-1), der eingerichtet ist, dem Schalter, übereinstimmend mit einem Steuersignal, ein Pulsweitenmodulationssignal bereitzustellen;
wobei die Primärspule ein erstes Ende, ein zweites Ende und eine vorbestimmte Induktanz aufweist, wobei ein Ende der Primärspule an eine Gleichspannung angeschlossen ist,
wobei der Schalter an das zweite Ende der Primärspule angeschlossen und eingerichtet ist, einen Strom in der Primärspule, übereinstimmend mit dem Pulsweitenmodulationssignal, EIN und AUS zu schalten, und
wobei die Steuereinheit eingerichtet ist, eine EIN-Zeit des Stroms und eine Schalthäufigkeit des Pulsweitenmodulationssignals beruhend auf der Ausgangsleistung der Spannungsregeleinheit zu ermitteln und den Stromverbrauchswert beruhend auf der EIN-Zeit des Stroms, der Schalthäufigkeit der Pulsweitenmodulation, einem Wert der Gleichspannung und der vorbestimmten Primärspuleninduktanz zu berechnen.

7. Vorrichtung nach einem beliebigen vorhergehenden Anspruch, wobei die Steuereinheit eingerichtet ist, den Stromverbrauchswert übereinstimmend mit folgender Gleichung zu berechnen:

$$P = \frac{1}{2} \frac{V_i^2 \times t_{on}^2}{L_p} \times f(W),$$

dabei gilt:

$P$ ist der berechnete Stromverbrauchswert,
$V_i$ ist ein Wert der Spannung an der Primärspule,
$L_p$ ist eine Induktanz der Primärspule,
$t_{on}$ ist eine EIN-Zeit des Stroms in der Primärspule, und
$f(W)$ ist eine Schalthäufigkeit des Schalters.

8. Verfahren zur Berechnung von Stromverbrauch einer Vorrichtung, die eine Schalterbetriebsstromversorgung umfasst, wobei die besagte Schalterbetriebsstromversorgung einen Schalter (Q11; Q31) und einen Transformator (T11; T31) umfasst, wobei das Verfahren umfasst:

Gleichrichten und Glätten einer Wechselspannung, um eine Gleichspannung auszugeben;
Regeln zumindest eins von einer ersten Spannung ($V_c$), die von einer Spannung an einer Primärspule des besagten Transformators (T31) abgeleitet ist und einer zweiten Spannung ($V_{c2}$), die von einer Spannung an einer Sekundärspule des besagten Transformators (T11) abgeleitet ist;
Empfangen der besagten Gleichspannung an der Primärspule und Erzeugen einer Spannung ($V_s$) an der Se-kundärspule in Übereinstimmung mit Stromschwankungen in der Primärspule und Ein- oder Ausschalten der Gleichspannung an der Primärspule mit Pulsweitenmodulation (PWM); und
Berechnen einer EIN-Zeit des Schalters, beruhend auf der zumindest einen geregelten Spannung und Berechnen eines Stromversorgungswerts, beruhend auf der berechneten EIN-Zeit, einer Schalthäufigkeit des Schalters und einer Induktanz des Transformators.

9. Verfahren nach Anspruch 8, wobei ein Strom einer Primärspule des Transformators durch Pulsweitenmodulation EIN und AUS geschaltet wird, wobei das Verfahren weiter umfasst:

Ermitteln einer Antriebsspannung über die Primärspule;
Erzeugen einer Pulswellenform, die einen ersten Pegel, der einer EIN-Zeit des Stroms in der Primärspule entspricht und einen zweiten Pegel aufweist;
Ermitteln einer Größe des Stroms, beruhend auf der Antriebsspannung über die Primärspule, der EIN-Zeit des Stroms in der Primärspule und einer vorbestimmten Induktanz der Primärspule; und
Berechnen des Stromverbrauchwerts beruhend auf einer Gleichung:

$$P = \frac{1}{2}\frac{V_i^2 \times t_{on}^2}{L_p} \times f(W),$$

dabei gilt:

P ist der berechnete Stromverbrauchswert,
$V_i$ ist die Antriebsspannung,
$L_p$ ist die vorbestimmte Induktanz der Primärspule,
t ist die EIN-Zeit des Stroms in der Primärspule, und
f(W) ist eine Schalthäufigkeit der Pulsweitenmodulation.

**10.** Verfahren nach Anspruch 9, weiter umfassend:

Abtasten der Antriebsspannung;
Klemmen der abgetasteten Antriebsspannung bei vorbestimmten Höchst- und Mindestwerten; und
Ermitteln der EIN-Zeit anhand der geklemmten Spannung.

**11.** Verfahren nach Anspruch 10, wobei das Abtasten der Antriebsspannung umfasst:

Transformieren der Antriebsspannung unter Verwendung eines zweiten Transformators (T32), der ein vorbestimmtes Wicklungsverhältnis hat, um die abgetastete Antriebsspannung auszugeben.

**12.** Verfahren nach Anspruch 10, wobei das Abtasten der Antriebsspannung umfasst:

Abschwächung der Antriebsspannung übereinstimmend mit einem vorbestimmten Verhältnis, um die abgetastete Antriebsspannung auszugeben.

**Revendications**

**1.** Appareil pour mesurer une consommation d'énergie comprenant une alimentation électrique à découpage, ladite alimentation électrique à découpage comprenant un commutateur (Q11 ; Q31) et un transformateur (T11 ; T31), ledit transformateur comprenant un enroulement primaire et un enroulement secondaire, et l'appareil comprenant en outre :

un redresseur (100 ; 300) agencé pour redresser et lisser une tension C.A. d'entrée du redresseur afin de produire en sortie une tension C.C. ;
une unité de régulation de tension (104 ; R36 ; ZD32) agencée pour réguler au moins l'une d'une première tension ($V_{c2}$) dérivée d'une tension à l'enroulement primaire dudit transformateur (T31) et d'une seconde tension ($V_c$) dérivée d'une tension à l'enroulement secondaire dudit transformateur (T11) ; et
dans lequel l'enroulement primaire est agencé pour recevoir ladite tension C.C. et l'enroulement secondaire est agencé pour produire une tension ($V_S$) en fonction des fluctuations de courant dans l'enroulement primaire, et dans lequel le commutateur est agencé pour activer ou désactiver la tension C.C. à l'enroulement primaire par modulation de largeur d'impulsion, PWM,
**caractérisé en ce que** l'appareil comprend en outre une unité de commande (105 ; 305) configurée pour calculer un temps d'activation du commutateur en fonction de l'au moins une tension régulée produite en sortie par l'unité de régulation de tension (104 ; R36, ZD32), et calculer une valeur de consommation d'énergie en fonction du temps d'activation calculé, d'une fréquence de commutation du commutateur et d'une inductance du transformateur.

**2.** Appareil selon la revendication 1, comprenant un moyen d'affichage (106 ; 306) pour monter la valeur de consommation d'énergie à un utilisateur.

**3.** Appareil selon la revendication 1 ou 2, comprenant des premier et second transformateurs (T31, T32), dans lequel l'unité de régulation de tension est connectée à l'enroulement secondaire du second transformateur (T32) et le premier transformateur (T31) est utilisé pour alimenter des éléments fonctionnels de l'appareil.

4. Appareil selon la revendication 1 ou 2, dans lequel l'unité de régulation de tension est agencée pour réguler ladite première tension, l'unité de régulation de tension comprenant :

une section de réduction de tension (R34, R35) agencée pour réduire ladite première tension en dessous d'un certain niveau ;
un premier circuit de verrouillage de niveau (ZD31) agencé pour verrouiller la première tension réduite à un premier niveau de tension constant ;
un transformateur (T32) agencé pour transformer ladite première tension verrouillée ; et
un second circuit de verrouillage de niveau (ZD32) agencé pour verrouiller la première tension transformée à un second niveau de tension constant.

5. Appareil selon la revendication 1 ou 2, dans lequel l'unité de régulation de tension est agencée pour réguler ladite seconde tension, l'unité de régulation de tension comprenant :

une section de réduction de tension (R13, R14) agencée pour réduire ladite seconde tension en dessous d'un certain niveau ; et
un circuit de verrouillage de niveau (ZD11) agencé pour verrouiller la seconde tension réduite à un niveau de tension constante.

6. Appareil selon la revendication 1, comprenant en outre :

un modulateur de largeur d'impulsion (101-1) agencé pour fournir un signal de modulation de largeur d'impulsion au commutateur, en fonction d'un signal de commande ;
dans lequel l'enroulement primaire a une première extrémité, une seconde extrémité et une inductance prédéterminée, une extrémité de l'enroulement primaire étant connectée à une tension C.C.,
dans lequel le commutateur est connecté à la seconde extrémité de l'enroulement primaire et est agencé pour activer ou désactiver un courant dans l'enroulement primaire en fonction du signal de modulation de largeur d'impulsion, et
dans lequel l'unité de commande est agencée pour déterminer un temps d'activation du courant et une fréquence de commutation du signal de modulation de largeur d'impulsion en fonction de la sortie de l'unité de régulation de tension, et pour calculer la valeur de consommation d'énergie en fonction du temps d'activation du courant, de la fréquence de commutation de la modulation de largeur d'impulsion, d'une valeur de la tension C.C et de l'inductance prédéterminée de l'enroulement primaire.

7. Appareil selon l'une quelconque des revendications précédentes, dans lequel l'unité de commande est agencée pour calculer la valeur de consommation d'énergie en fonction d'une équation :

$$P = \frac{1}{2}\frac{V_i^2 \times t_{on}^2}{L_p} \times f(W),$$

où : P est la valeur de consommation d'énergie calculée,
$V_i$ est une valeur de la tension à l'enroulement primaire,
$L_p$ est une inductance de l'enroulement primaire,
$t_{on}$ est un temps d'activation du courant dans l'enroulement primaire, et
$f(W)$ est une fréquence de commutation du commutateur.

8. Procédé de calcul d'une consommation d'énergie d'un appareil comprenant une alimentation électrique à découpage, ladite alimentation électrique à découpage comprenant un commutateur (Q11 ; Q31) et un transformateur (T11 ; T31), ledit procédé comprenant :

le redressement et le lissage d'une tension C.A. afin de produire en sortie une tension C.C. ;
la régulation d'au moins l'une d'une première tension ($V_c$) dérivée d'une tension à un enroulement primaire dudit transformateur (T31) et d'une seconde tension ($V_{c2}$) dérivée d'une tension à un enroulement secondaire dudit transformateur (T11) ;

la réception de ladite tension C.C. à l'enroulement primaire et la production d'une tension ($V_S$) à l'enroulement secondaire en fonction des fluctuations de courant dans l'enroulement primaire, et

l'activation ou la désactivation de la tension C.C. à l'enroulement primaire par modulation de largeur d'impulsion, PWM ; et

le calcul d'un temps d'activation du commutateur en fonction de l'au moins une tension régulée, et le calcul d'une valeur de consommation d'énergie en fonction du temps d'activation calculé, d'une fréquence de commutation du commutateur et d'une inductance du transformateur.

9.  Procédé selon la revendication 8, dans lequel un courant d'un enroulement primaire du transformateur est activé ou désactivé par modulation de largeur d'impulsion, le procédé comprenant en outre :

la détermination d'une tension de commande aux bornes de l'enroulement primaire ;

la génération d'une forme d'onde d'impulsion d'un premier niveau correspondant au temps d'activation du courant dans l'enroulement primaire et d'un second niveau ;

la détermination d'une grandeur du courant en fonction de la tension de commande aux bornes de l'enroulement primaire, du temps d'activation du courant dans l'enroulement primaire, et d'une inductance prédéterminée de l'enroulement primaire ; et

le calcul de la valeur de consommation d'énergie en fonction d'une équation :

$$P = \frac{1}{2}\frac{V_i^2 \times t_{on}^2}{L_p} \times f(W),$$

où :

$P$ est la valeur de consommation d'énergie calculée,

$V_i$ est la tension de commande,

$L_p$ est l'inductance prédéterminée de l'enroulement primaire,

$t$ est le temps d'activation du courant dans l'enroulement primaire, et

$f(W)$ est une fréquence de commutation de la modulation de largeur d'impulsion.

10. Procédé selon la revendication 9, comprenant en outre :

l'échantillonnage de la tension de commande ;

le verrouillage du niveau de la tension de commande échantillonnée à des valeurs maximum et minimum prédéterminées ; et

la détermination du temps d'activation à partir de la tension verrouillée.

11. Procédé selon la revendication 10, dans lequel l'échantillonnage de la tension de commande comprend :

la transformation de la tension de commande au moyen d'un second transformateur (T32) ayant un rapport de spires prédéterminé afin de produire en sortie la tension de commande échantillonnée.

12. Procédé selon la revendication 10, dans lequel l'échantillonnage de la tension de commande comprend :

l'atténuation de la tension de commande en fonction d'un rapport prédéterminé afin de produire en sortie la tension de commande échantillonnée.

# FIG. 1

FIG. 2A
(Vgs)

FIG. 2B
(Vds)

FIG. 2C
(Ip)

FIG. 2D
(Vs)

FIG. 2E
(Is)

FIG. 2F
(Va)

FIG. 2G
(Vc)

# FIG. 3

EP 1 396 728 B1

FIG. 4A (Vgs)

FIG. 4B (Vds)

FIG. 4C (Ip)

FIG. 4D (Vs)

FIG. 4E (Is)

FIG. 4F (Va1)

FIG. 4G (Vc1)

FIG. 4H (Vt1)

FIG. 4I (Vc2)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 6320766 B1